# EUROPEAN PATENT APPLICATION

(11) **EP 3 901 982 A1**
(43) Date of publication of application: **27.10.2021**
(21) Application number: 20170478.0
(22) Date of filing: 20.04.2020
(51) Int. Cl.: H01J 37/147, H01J 37/28

(54) **AN INSPECTION TOOL, INSPECTION TOOL OPERATING METHOD, AND NON-TRANSITORY COMPUTER READABLE MEDIUM**

(71) Applicant: ASML Netherlands B.V., 5500 AH Veldhoven (NL)
(72) Inventor: VAN RENS, Jasper Frans Mathijs, 5500 AH Veldhoven (NL); MANGNUS, Albertus Victor Gerardus, 5500 AH Veldhoven (NL)
(74) Representative: ASML Netherlands B.V.

(57) **Abstract**

The present disclosure relates to an inspection tool having a charged particle source to provide a charged particle beam, a sample holder to hold a sample, and a scanning system configured to scan the charged particle beam over an area of the sample in a scanning pattern. The scanning system may comprise a microwave cavity to provide a first oscillating magnetic field to periodically deflect the charged particle beam in order to scan the charged particle beam over the area of the sample. The charged particle beam may be an electron beam, so that the inspection tool may be a scanning electron microscope. The scanning system may be configured to continuously scan the charged particle beam over the area of the sample.

## Description

### FIELD

The present disclosure relates to an inspection tool, and more particularly an inspection tool with an enhanced scan rate in excess of 1 GHz. The present disclosure further relates to a method for operating an inspection tool and a non-transitory computer readable medium storing a set of instructions that is executable by one or more processors of an inspection tool.

### BACKGROUND

In manufacturing processes of integrated circuits (ICs), unfinished or finished circuit components are inspected to ensure that they are manufactured according to design and are free of defects. Inspection systems utilizing optical microscopes or charged particle (e.g. electron) beam microscopes, such as a scanning electron microscope (SEM) can be employed.

Scanning a generated electron beam over a sample is typically carried out by electric or magnetic deflectors using plates or coils, respectively. The scan rate is generally in the MHz range.

### SUMMARY

In one aspect, the present disclosure is directed to an inspection tool having a charged particle source to provide a charged particle beam, a sample holder to hold a sample, and a scanning system configured to scan the charged particle beam over an area of the sample in a scanning pattern. The scanning system may comprise a microwave cavity to provide a first oscillating magnetic field to periodically deflect the charged particle beam in order to scan the charged particle beam over the area of the sample. The charged particle beam may be an electron beam, so that the inspection tool may be a scanning electron microscope. The scanning system may be configured to continuously scan the charged particle beam over the area of the sample.

Scanning may be carried out in a single direction so that a single-mode microwave cavity may be used. The scanning system may be configured to provide a second oscillating magnetic field different from the first oscillating magnetic field to periodically deflect the charged particle beam in order to scan the charged particle beam over the area of the sample. The second oscillating magnetic field may be provided by the same microwave cavity configured to provide the first oscillating magnetic field. The microwave cavity may then be a dual-mode microwave cavity. The second oscillating magnetic field may alternatively be provided by another microwave cavity, which may be a single-mode microwave cavity. The microwave cavity configured to provide the first oscillating magnetic field may then be referred to as the first microwave cavity, and the microwave cavity configured to provide the second oscillating magnetic field may then be referred to as the second microwave cavity.

Having two oscillating magnetic fields enables to scan over an area of the sample with a 2D scanning pattern. Preferably, the scanning system is configured to provide the first oscillating magnetic field perpendicular to the second oscillating magnetic field. Hence, the first and second oscillating magnetic fields are configured to periodically deflect the charged particle beam in different directions. However, it is also envisaged that the second oscillating magnetic field is configured to periodically deflect the charged particle beam in the same direction, for instance opposite to the first oscillating magnetic field enabling to direct the charged particle beam through a specific point in space while allowing a canning pattern to be generated.

When the scanning system is configured such that the first and second oscillating magnetic fields are configured to periodically deflect the charged particle beam in different directions, the scanning system may further be configured to operate the first oscillating magnetic field at a different frequency than the second oscillating magnetic field. When the two oscillating magnetic fields are not phase-locked, for instance because the microwave input signals to the respective microwave cavities are not phase-locked, the charged particle beam will eventually cover the entire to be scanned area of the sample. In an embodiment, the scanning system is configured to operate the first oscillating magnetic field and the second oscillating magnetic field such that the first and second oscillating magnetic field are phase-locked, for instance by phase-locking the microwave input signals. This enables to create a Lissajous pattern as scanning pattern. The Lissajous pattern may be repeated to allow averaging techniques to improve accuracy of the measurement. A ratio between the two different frequencies may be rational so that a closed Lissajous pattern is formed that can easily be repeated.

In an embodiment, the inspection tool further comprises a detector system to detect back-scattered or secondary charged particles from the sample. The detector system may comprise an imaging system to image the back-scattered or secondary charged particles from the sample directly on a detector, e.g. a pixelated detector.

The detector system may be configured to periodically deflect the charged particles from the sample to form an image on a detector, e.g. a pixelated charged particle camera, for instance using plates or coils. The detector system may comprise a microwave cavity configured to provide an oscillating magnetic field similar to the first oscillating magnetic field to periodically deflect the charged particles from the sample to form an image on a detector, e.g. a pixelated charged particle camera. This enables to spatially resolve the different arrival times of the charged particles originating from different positions on the sample. The detector system may further comprise a lens system to focus the back-scattered or secondary charged particles from the sample before or after being deflected by the microwave cavity.

The detector system may be configured to deflect the back-scattered or secondary charged particles from the sample in a deflection pattern similar to the scanning pattern to form an image on a detector. This may for instance be carried out by providing identical or at least similar microwave cavities for creating the deflection pattern as used for creating the scanning pattern. The detector system and the scanning system may be configured such that the deflection pattern of the detector system and the scanning pattern are phase-locked, for instance by using microwave input signals that are phase-locked, e.g. by originating from the same microwave source. The deflection pattern and scanning pattern may also differ, e.g. in scan rate. The scan rate of the scanning pattern may for instance be a plurality of the scan rate of the deflection pattern.

The detector system and the scanning system may be configured such that the deflection pattern of the detector system and the scanning pattern have a non-zero phase difference of e.g. 90 degrees. This enables to use a different relation between the deflection pattern and the scanning pattern allowing to improve temporal resolution of at least some portions of the scanning pattern.

The inspection tool may further comprise an objective lens arranged between the scanning system and the sample holder. The scanning system may include a counteracting microwave cavity configured to deflect the charged particle beam from the microwave cavity providing the first oscillating magnetic field towards an optical axis, preferably an origin of the objective lens. This enables to avoid or reduce off-axis aberrations during the scan. The counteracting microwave cavity may use the same frequency as the first oscillating magnetic field. The counteracting microwave cavity may use a phase or amplitude that is different from the phase or amplitude of the first oscillating magnetic field, respectively, e.g. to improve the counteracting deflection function.

The inspection tool may further comprise a beam separator, e.g. a Wien filter, to direct the charged particles from the sample towards the detector system. The beam separator may be arranged between the sample holder and the scanning system. Alternatively, the microwave cavity may be arranged between the sample holder and the beam separator. In that case, another microwave cavity may be arranged between the beam separator and the detector system to counteract the periodic deflection imposed on the back-scattered or secondary charged particles from the sample by the microwave cavity arranged between the sample holder and the beam separator.

The scanning system may be configured to provide one or more oscillating magnetic fields that are higher-order harmonics of the first oscillating magnetic field to be combined with the first oscillating magnetic field to approximate a triangular-shaped oscillating magnetic field or to improve the linearity of a portion of the initially sinusoidal wave form. Additionally, the scanning system may be configured to provide one or more oscillating magnetic fields that are higher-order harmonics of the second oscillating magnetic field to be combined with the second oscillating magnetic field to approximate a triangular-shaped oscillating magnetic field. This can be used to increase the linearity of the Lissajous pattern.

In another aspect, the present disclosure is directed to a method of scanning a sample in an inspection tool. The method may include generating a charged particle beam, and passing the charged particle beam through a microwave cavity and towards a sample to scan the charged particle beam over an area of the sample in a scanning pattern. Scanning may be done continuously. The charged particle beam may be an electron beam.

The scanning pattern may be a 2D pattern, for instance to reach every spot within the sample area to be scanned or to create a Lissajous pattern.

The method may further comprise the step of capturing back-scattered or secondary charged particles from the sample and imaging said charged particles on a detector. A further microwave cavity may be provided to deflect said back-scattered or secondary charged particles from the sample to form an image on the detector in accordance with a deflection pattern. The deflection pattern may be similar or identical to the scanning pattern.

In a further aspect, the present disclosure is directed to a non-transitory computer readable medium storing a set of instructions that is executable by one or more processors of an inspection tool to cause the inspection tool to perform a method of inspecting a sample, the method comprising:
a. activating a charged particle source to generate a charged particle beam;
b. operating a microwave cavity to scan the charged particle beam passing through the microwave cavity and towards a sample over an area of the sample in a scanning pattern. The scanning pattern may be a 2D pattern, e.g. a Lissajous pattern.

The set of instructions that is executable by one or more processors of an inspection tool may cause the inspection tool to further perform deflecting back-scattered or secondary charged particles from the sample to form an image on the detector in accordance with a deflection pattern. The deflection pattern may be similar to the scanning pattern.

In yet another aspect, the present disclosure is directed to an inspection tool comprising a charged particle source to generate charged particles, and a first microwave deflection cavity to direct charged particles from the charged particle source towards a sample. The first microwave deflection cavity may be a microwave cavity as described above and the microwave cavities described above may be a first microwave deflection cavity as described in this aspect. The first microwave deflection cavity may be configured to scan the sample at a scan rate in excess of 1 GHz. The charged particle source may be an electron source.

The inspection tool may further comprise a second microwave deflection cavity to direct secondary charged particles generated in response to the charged particles directed at the sample impacting the sample towards a detector. The second microwave deflection cavity may be a microwave cavity as described above and the microwave cavities described above may be a second microwave deflection cavity as described in this aspect. The first and second microwave deflection cavity may be configured to be operated in sync.

In yet another aspect, the present disclosure is directed to a method of scanning a sample in a SEM, the method comprising generating charged particles via a charged particle source, and passing the charged particles through a first microwave deflection cavity and towards a sample. This preferably enables the sample to be scanned at a scan rate in excess of 1 GHz. The charged particle source may be an electron source.

The method may further comprise in response to the charged particles directed at the sample impacting the sample and causing secondary charged particles to be generated, passing the secondary charged particles through a second microwave deflection cavity that is synchronized with the first microwave deflection cavity to cause the secondary charged particles to be deflected towards a detector.

The method may further comprise scanning the sample in a Lissajous pattern at a scan rate in excess of 1 GHz. The Lissajous pattern may be imaged directly on the detector.

The first and second microwave deflection cavity may be synchronized with a predetermined non-zero phase difference of e.g. 90 degrees.

In a further aspect, the present disclosure is directed to a non-transitory computer readable medium storing a set of instructions that is executable by one or more processors of an inspection tool to cause the inspection tool to perform a method of inspecting a sample , the method comprising:
a. activating a charged particle source to generate charged particles;
b. operating a first microwave deflection cavity to scan a sample with the charged particles passing the first microwave deflection cavity and towards the sample at a scan rate in excess of 1 GHz.

The set of instructions that is executable by one or more processors of an inspection tool may cause the inspection tool to further perform operating a second microwave deflection cavity in sync with the first microwave deflection cavity to cause secondary charged particles generated in response to charged particles being directed at the sample and impacting the sample to be deflected towards a detector.

Operating the first microwave deflection cavity may cause the sample to be scanned in a Lissajous pattern at a scan rate in excess of 1 GHz

To avoid unduly repetition of embodiments and features, it is explicitly noted here that embodiments or features described in relation to one aspect may readily be combined with another aspect where appropriate.

### BRIEF DESCRIPTION OF THE DRAWINGS

Embodiments of the present disclosure will now be described, by way of example only, with reference to the accompanying schematic drawings, in which:
- Figure 1 depicts a schematic diagram illustrating an exemplary charged particle beam inspection system, consistent with embodiments of the present disclosure;
- Figure 2 schematically depicts an exemplary configuration of a scanning electron microscope that can be part of the exemplary electron beam inspection system of Fig. 1, consistent with embodiments of the present disclosure;
- Figure 3 schematically depicts another exemplary configuration of a scanning electron microscope that can be part of the exemplary electron beam inspection system of Fig. 1, consistent with embodiments of the present disclosure;
- Figure 4 schematically depicts an exemplary scanning pattern obtainable with for instance the exemplary scanning electron microscopes of Figs. 2 and 3, consistent with embodiments of the present disclosure;
- Figure 5a schematically depicts a cross-sectional view of an exemplary microwave cavity that can be part of the exemplary scanning electron microscopes of Figs. 2 and 3, consistent with embodiments of the present disclosure;
- Figure 5b schematically depicts another cross-sectional view of the microwave cavity of Fig. 5a;
- Figure 6 schematically depicts a process flowchart representing an exemplary method of inspecting a sample using an inspection tool, consistent with embodiments of the present disclosure; and
- Figure 7 schematically depicts a process flowchart representing another exemplary method of inspecting a sample using an inspection tool, consistent with embodiments of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented, and only the differences with respect to the individual embodiments are described. The implementations set forth in the following description of exemplary embodiments do not represent all implementations. Instead, they are merely examples of apparatuses and methods consistent with aspects related to the disclosed embodiments as recited in the appended claims.

Relative dimensions of components in drawings may be exaggerated for clarity. As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

The present disclosure is directed to an imaging apparatus for imaging very small features, typically in the nanometer range, which is about 1/10,000th to 1/1,000th of the thickness of a hair. When taking a picture with a photo camera, the camera captures light reflected or emitted by the different objects in the picture. Visible light is also suitable for optical microscopes, but due to its wavelengths in the range 400-700nm, it is not suitable for imaging features smaller than these wavelengths, so that other radiation sources are used to image these features.

An imaging apparatus known as a scanning electron microscope uses electrons as a radiation source, which are negatively charged particles that are normally known as the particles flowing through electrical wiring e.g. to power our appliances at home. In a scanning electron microscope a focused electron beam is scanned over the sample and as with the photo camera, electrons reflected or emitted by the sample are captured to form an image.

Hence, the sample is bombarded with electrons, pixel-by-pixel until each pixel of the image has received a predetermined amount of electrons. Due to the different nature of electrons compared to visible light, i.e. the electrons are particles having a mass and a negative charge, the electrons may cause the sample to locally shrink or be locally charged upon impact resulting in an image that is not representative for the original features anymore. The amount of shrinkage and charging is dependent on a maximum amount of electrons received by the sample per unit of time.

Some embodiments of the present disclosure relate to a scanning electron microscope that redistributes the amount of electrons received by the sample in time thereby lowering the maximum amount of electrons received by the sample per unit of time. The inventors considered to change the continuously supplied electron beam into a pulsed electron beam by alternatingly interrupting the beam. However, this is inefficient as it only uses a portion of the electrons while the others are wasted and thus it takes longer to obtain an image. The inventors also considered increasing the scan rate, but this turned out to be challenging for conventional scanning electron microscopes as these devices use plates to create electric fields or coils to create magnetic fields. It proved to be difficult to increase the scan rate due to the finite capacitance of the plates or the finite inductance of the coils. The present disclosure circumvents this challenge by abandoning the use of plates or coils to create oscillating electric or magnetic fields to move electrons in the electron beam, but instead in some embodiments uses one or more microwave cavities in which microwaves form standing waves to create oscillating magnetic fields suitable to deflect the electron beam at frequencies allowing a faster scan rate. As a result thereof, the electron beam can be scanned faster over the sample, so that the number of electrons received by a pixel of the sample per unit of time is reduced and thus the shrinkage or charging effects of the sample can be reduced as the energy or charge has sufficient time to diffuse away through the sample. To obtain an image in which each pixel has received a predetermined amount of electrons, the scanning pattern can be repeated until the predetermined amount of electrons per pixel has been reached. Another benefit may be that the time to scan the sample may be reduced thereby increasing throughput when e.g. the increased scan rate is combined with a higher electron beam current thereby accepting more shrinkage or charging effects, possibly as much shrinkage or charging effects as in prior art scanning electron microscopes to obtain maximum throughput for similar or equal image quality as in prior art scanning electron microscopes.

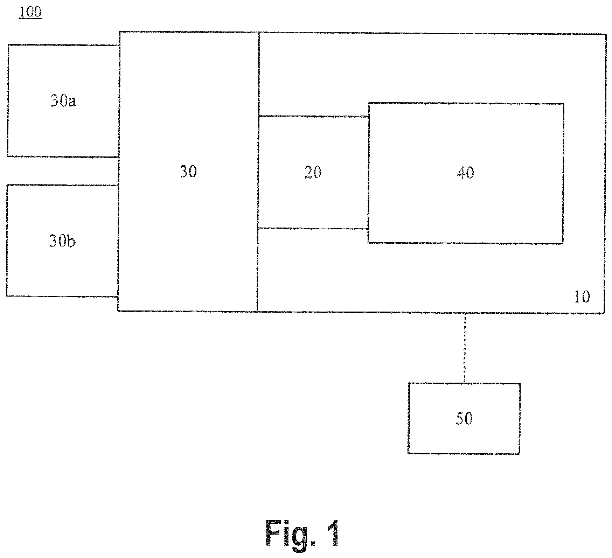

Reference is now made to Fig. 1, which illustrates an exemplary charged particle beam inspection (EBI) system 100 consistent with embodiments of the present disclosure. As shown in Fig. 1, charged particle beam inspection system 100 includes a main chamber 10, a load-lock chamber 20, an inspection tool 40, e.g. a scanning electron microscope, and an equipment front end module (EFEM) 30. Inspection tool 40 is located within main chamber 10.

EFEM 30 includes a first loading port 30a and a second loading port 30b. EFEM 30 may include additional loading port(s). First loading port 30a and second loading port 30b receive wafer front opening unified pods (FOUPs) that contain wafers (e.g., semiconductor wafers or wafers made of other material(s)) or samples to be inspected (wafers and samples are collectively referred to as "wafers" hereafter). One or more robot arms (not shown) in EFEM 30 transport the wafers to load-lock chamber 20.

Load-lock chamber 20 is connected to a load/lock vacuum pump system (not shown), which removes gas molecules in load-lock chamber 20 to reach a first pressure below atmospheric pressure. After reaching the first pressure, one or more robot arms (not shown) transport the wafer from load-lock chamber 20 to main chamber 10. Main chamber 10 is connected to a main chamber vacuum pump system (not shown), which removes gas molecules in main chamber 10 to reach a second pressure below the first pressure. After reaching the second pressure, the wafer is subject to inspection by inspection tool 40. In some embodiments, inspection tool 40 may comprise a single-beam scanning electron microscope. In other embodiments, inspection tool 40 may comprise a multibeam scanning electron microscope.

Controller 50 may be electronically connected to inspection tool 40 and may be electronically connected to other components as well. Controller 50 may be a computer configured to execute various controls of charged particle beam inspection system 100. Controller 50 may also include processing circuitry configured to execute various signal and image processing functions. While controller 50 is shown in Fig. 1 as being outside of the structure that includes main chamber 10, load-lock chamber 20, and EFEM 30, it is appreciated that controller 50 can be part of the structure.

While the present disclosure provides examples of main chamber 10 housing an inspection tool 40, it should be noted that aspects of the disclosure in their broadest sense, are not limited to a chamber housing an inspection tool. Rather, it is appreciated that the foregoing principles may be applied to other chambers as well.

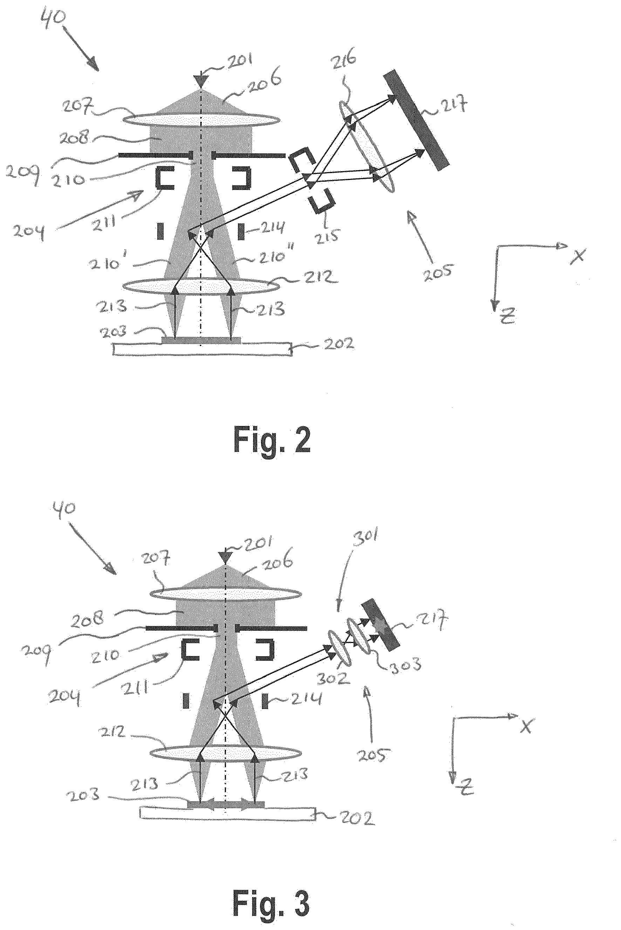

Reference is now made to Fig. 2, which illustrates an exemplary configuration of a scanning electron microscope 40 that can be part of the exemplary charged particle beam inspection system 100 of Fig. 1, consistent with embodiments of the present disclosure. Scanning electron microscope 40 (also referred to herein as SEM 40) may comprise an electron source 201, a sample holder 202 to hold a sample 203, e.g. a wafer, a scanning system 204 and a detection system 205. It may be appreciated that other commonly known components of SEM 40, such as, for example, a source conversion unit, a primary projection optical system or a secondary imaging system, may be added/omitted as appropriate or described as part of the electron source 201, the scanning system 204 or the detection system 205.

The electron source 201 is configured to provide electrons in the form of an electron beam 206. A condenser lens 207 may be arranged downstream of the electron source to shape the electron beam 206 and provide e.g. a parallel electron beam 208. An objective aperture 209 may be provided to form an electron beam 210 with a predetermined beam current.

The scanning system 204 includes a first microwave cavity 211 configured to periodically deflect the electron beam 210 in X-direction. Two extreme positions of electron beam 210 in X-direction have been depicted and denoted reference symbols 210'and 210". The first microwave cavity 211, which may alternatively referred to as RF (radio frequency) cavity or microwave deflection cavity, is a resonator in which microwaves applied to the microwave cavity bounce back and forth between walls of the microwave cavity. At a resonance of the microwave cavity, standing waves are formed resulting in a first oscillating magnetic field having the same frequency as the resonance of the microwave cavity. By passing electrons through the first microwave cavity 211, the electrons are subjected to the first oscillating magnetic field and periodically deflected while being directed to the sample 203, so that the electron beam 210 is scanned over the sample 201. Fig. 2 depicts this for the X-direction.

The periodically deflected electron beam 210 is focused into a spot on the sample by objective lens 212.

A frequency of the first oscillating magnetic field can for instance be set by properly designing the first microwave cavity to have a resonance frequency at a desired frequency, so that a standing wave with the desired frequency can be created inside the first microwave cavity, which standing wave causes the first oscillating magnetic field. An amplitude of the first oscillating magnetic field can be controlled by adjusting an input power of the first microwave cavity. The amplitude may be set to correspond to a size of a to be scanned area on the sample.

Electrons impacting the sample 203 may cause secondary electrons 213, which are emitted from sample 203 in a direction opposite as the electrons in the electron beam 210. A beam separator 214 such as a Wien filter may be provided in between the sample holder 202 and the first microwave cavity 211 to deflect the secondary electrons towards the detection system 205 without affecting the electron beam 210.

In the example of Fig. 2, the detection system 205 includes a second microwave cavity 215, a lens 216 and a detector 217. The second microwave cavity 215 is preferably similar to the first microwave cavity, e.g. by having the same resonance frequency, and preferably fed with the same microwave input signal as the first microwave cavity 211 to phase-lock the corresponding oscillating magnetic fields although an amplitude of the oscillating magnetic fields may be different. A lens system, e.g. the lens 216, then focuses the secondary electrons into a spot on the detector 217, so that the spot is scanned over the detector in a detection pattern similar to the scanning pattern of electron beam 210 as provided by the first microwave cavity 211. In this way, the position on the detector 217 is directly correlated to a position on the sample 203.

Reference is now made to Fig. 3, which illustrates another exemplary configuration of a scanning electron microscope 40 that can be part of the exemplary electron beam inspection system 100 of Fig. 1, consistent with embodiments of the present disclosure. The main difference between the configuration of Fig. 2 and the configuration of Fig. 3 is the detection system 205. In the configuration of Fig. 3, the second microwave cavity is omitted and an imaging system 301 including one or more lenses, e.g. lenses 302 and 303, is provided to image the secondary electrons from the sample directly on the detector 217, so that the scanning pattern provided by the first microwave cavity 211 is directly imaged on the detector 217.

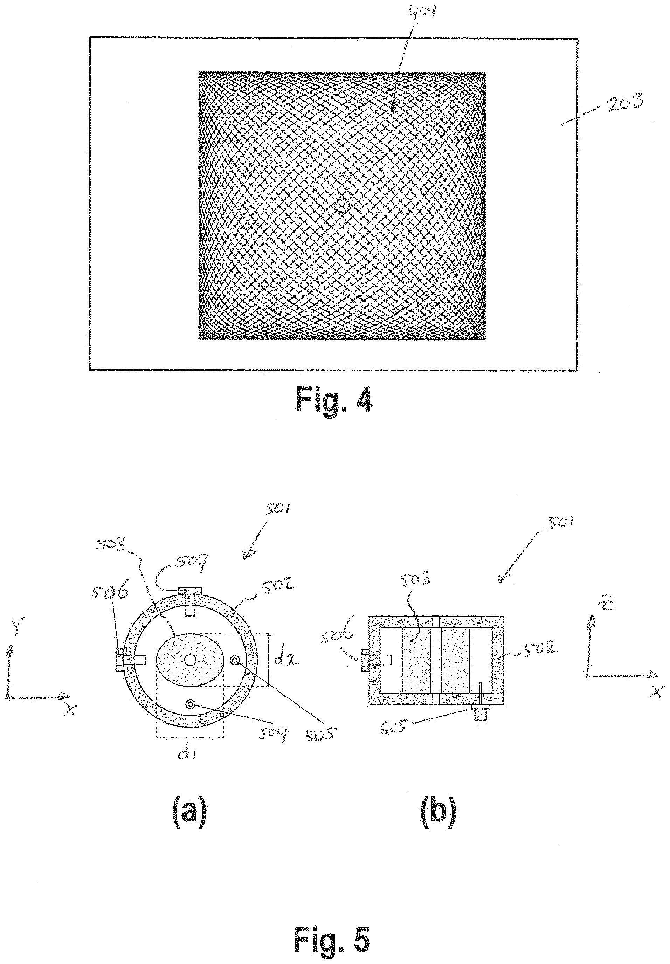

Although the above description only refers to a deflection in X-direction of the electron beam 210, the scanning system 204 may be configured to provide a second oscillating magnetic field different from the first oscillating magnetic field to periodically deflect the electron beam 210 in a direction other than the X-direction, namely, also at least partially in a Y-direction that is perpendicular to the depicted X- and Z-directions. To this end, the second oscillating magnetic field is preferably perpendicular to the first oscillating magnetic field. Further, the second oscillating magnetic field is preferably operated at a frequency other than the first oscillating magnetic field, so that in case the first and second oscillating magnetic fields are phase-locked, as is preferred, the scanning pattern forms a Lissajous pattern on the sample 203. An example of such a Lissajous pattern is depicted in Fig. 4, where a sample 203 is schematically depicted with a Lissajous figure 401 indicating the Lissajous scanning pattern. The area covered by the Lissajous figure 401 may span the entire sample 203, but may also cover only a portion of the sample 203 as in Fig. 4. Further, the Lissajous figure imaged on the detector 217 by cavity 215 in Fig. 2 may span the entire detector, or a portion of the detector, or span an area larger than the detector. In case of the latter, only the more linear portions of the Lissajous figure are detected and used for imaging.

A density of cross-overs in the Lissajous figure 401 is amongst others dependent on the used frequencies of the first and second oscillating magnetic fields. Suppose the first oscillating magnetic field is oscillating at a frequency f0 and the second oscillating magnetic field is oscillating at a frequency f = f0^{∗}(1+1/N), then the number of crossovers in a direction corresponding to the first or second oscillating magnetic field is N.

Although additional microwave cavities may be provided to provide the second oscillating magnetic field in the configurations of Figs. 2 and 3, it is preferred to use a dual mode microwave cavity as first microwave cavity 211 and preferably also as second microwave cavity 215, an example of which is depicted in Fig. 5a and 5b.

Figs. 5a and 5b depict a dual mode microwave cavity 501 having a cylindrical housing 502. The cross-section of Fig. 5a is perpendicular to a propagation direction of an electron beam passing through the microwave cavity 501, while Fig. 5b is parallel to said propagation direction. The microwave cavity further includes a dielectric core 503 that is elliptical in the cross-section shown in Fig. 5a. Hence, dimension d1 is larger than dimension d2 resulting in a resonance frequency in Y-direction that is different from a resonance frequency in X-direction, perpendicular to the Y-direction. By providing a microwave input signal to microwave feedthroughs 504 and 505, preferably the same, more preferably phase-locked microwave input signals, the first and second oscillating magnetic fields can be generated using a single microwave cavity. The microwave cavity 501 may further comprise tuning stubs 506, 507 to adjust the resonance frequency in the X- and Y-direction, respectively. An important advantage of using a dielectric core 503 is that it may reduce the necessary diameter of the cavity to a size that fits in a scanning electron microscope or that it may reduce the power consumption.

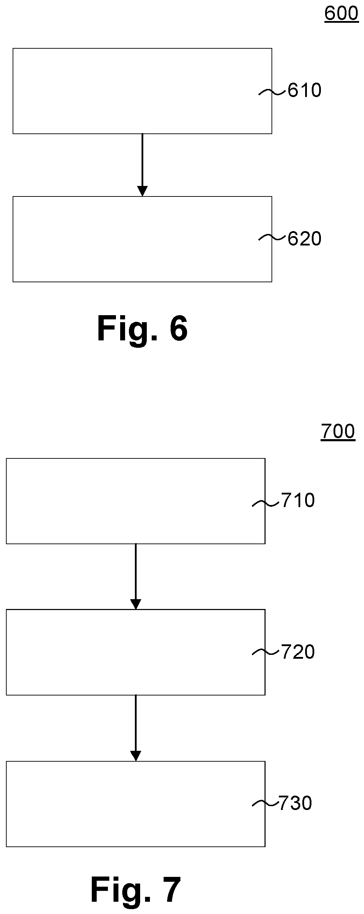

Reference is now made to Fig. 6, which illustrates a flowchart representing an exemplary method 600 of inspecting a sample using an inspection tool, consistent with embodiments of the present disclosure. Method 600 may be performed by controller 50 of EBI system 100, as shown in Fig. 1, for example. Controller 50 may be programmed to perform one or more blocks of method 600. Controller 50 may for instance include a non-transitory computer readable medium storing a set of instructions that is executable by one or more processors of an inspection tool, e.g. one or more processors of controller 50, to cause the inspection tool to perform one or more blocks of method 600. Common forms of non-transitory media include, for example, a floppy disk, a flexible disk, hard disk, solid state drive, magnetic tape, or any other magnetic data storage medium, a Compact Disc Read Only Memory (CD-ROM), any other optical data storage medium, any physical medium with patterns of holes, a Random Access Memory (RAM), a Programmable Read Only Memory (PROM), and Erasable Programmable Read Only Memory (EPROM), a FLASH-EPROM or any other flash memory, Non-Volatile Random Access Memory (NVRAM), a cache, a register, any other memory chip or cartridge, and networked versions of the same.

In step 610, a charged particle source (e.g., electron source 201 of Figs. 2 and 3) may be activated to generate a charged particle beam of charged particles (e.g. electron beam 206 of Figs. 2 and 3). The charged particle source may be activated by a controller (e.g., controller 50 of Fig. 1). For example, the charged particle source may be controller to emit primary electrons to form an electron beam along a primary optical axis. The charged particle source may be activated remotely, for example, using a software, an application, or a set of instructions for a processor of a controller to power the charged particle source through a control circuitry.

In step 620, a microwave cavity (e.g. a microwave cavity 211 of Figs. 2 and 3) is operated to scan the charged particle beam passing through the microwave cavity and towards a sample over an area of the sample in a scanning pattern. A resonance frequency of the microwave cavity may be set to allow a scan rate of at least 1GHz. Compared to a scan rate of 100MHz, this results in a reduction of the charge deposited per scan to only 10% of a 100MHz scan rate, resulting in an order of magnitude less charge and resulting in significantly reduced beam induced charging and shrinkage. Microwave cavities can easily have resonance frequencies that are a multitude of 1GHz, so that the charge deposited per scan can even be further reduced.

Reference is now made to Fig. 7, which illustrates a flowchart representing another exemplary method 700 of inspecting a sample using an inspection tool, consistent with embodiments of the present disclosure. Method 700 may be performed by controller 50 of EBI system 100, as shown in Fig. 1, for example. Controller 50 may be programmed to perform one or more blocks of method 600. Controller 50 may for instance include a non-transitory computer readable medium storing a set of instructions that is executable by one or more processors of an inspection tool, e.g. one or more processors of controller 50, to cause the inspection tool to perform one or more blocks of method 600. Common forms of non-transitory media include, for example, a floppy disk, a flexible disk, hard disk, solid state drive, magnetic tape, or any other magnetic data storage medium, a Compact Disc Read Only Memory (CD-ROM), any other optical data storage medium, any physical medium with patterns of holes, a Random Access Memory (RAM), a Programmable Read Only Memory (PROM), and Erasable Programmable Read Only Memory (EPROM), a FLASH-EPROM or any other flash memory, Non-Volatile Random Access Memory (NVRAM), a cache, a register, any other memory chip or cartridge, and networked versions of the same.

In step 710, a charged particle source (e.g., electron source 201 of Figs. 2 and 3) may be activated to generate a charged particle beam of charged particles (e.g. electron beam 206 of Figs. 2 and 3). The charged particle source may be activated by a controller (e.g., controller 50 of Fig. 1). For example, the charged particle source may be controller to emit primary electrons to form an electron beam along a primary optical axis. The charged particle source may be activated remotely, for example, using a software, an application, or a set of instructions for a processor of a controller to power the charged particle source through a control circuitry.

In step 720, a first microwave deflection cavity is operated to scan a sample with the charged particles passing the first microwave deflection cavity and towards the sample at a scan rate in excess of 1 GHz. Compared to a scan rate of 100MHz, this results in a reduction of the charge deposited per scan to only 10% of a 100MHz scan rate, resulting in an order of magnitude less charge and resulting in significantly reduced beam induced charging and shrinkage. Microwave cavities can easily have resonance frequencies that are a multitude of 1GHz, so that the charge deposited per scan can even be further reduced.

In step 730, a second microwave deflection cavity is operated in sync with the first microwave deflection cavity to cause secondary charged particles generated in response to charged particles being directed at the sample and impacting the sample to be deflected towards a detector. Operating in sync means that there is a fixed time-related relationship between the deflection caused by the first microwave deflection cavity and the deflection caused by the second microwave deflection cavity, e.g. because the deflection caused by the first microwave deflection cavity is in phase-lock with the deflection caused by the second microwave deflection cavity, or the scan rate of the second microwave deflection cavity is equal to the scan rate of the first microwave deflection cavity.

The embodiments may further be described using the following clauses:
1. An inspection tool including:
   - a charged particle source to provide a charged particle beam;
   - a sample holder to hold a sample; and
   - a scanning system configured to scan the charged particle beam over an area of the sample in a scanning pattern,
   wherein the scanning system comprises a microwave cavity to provide a first oscillating magnetic field to periodically deflect the charged particle beam in order to scan the charged particle beam over the area of the sample.
2. An inspection tool according to clause 1, wherein the charged particle beam is an electron beam.
3. An inspection tool according to clause 1, wherein the scanning system is configured to continuously scan the charged particle beam over the area of the sample.
4. An inspection tool according to clause 1, wherein the scanning system is configured to provide a second oscillating magnetic field different from the first oscillating magnetic field to periodically deflect the charged particle beam in order to scan the charged particle beam over the area of the sample.
5. An inspection tool according to clause 4, wherein said microwave cavity configured to provide the first oscillating magnetic field is also configured to provide the second oscillating field.
6. An inspection tool according to clause 4, wherein the microwave cavity is a first microwave cavity, and wherein the scanning system comprises a second microwave cavity configured to provide the second oscillating magnetic field.
7. An inspection tool according to clause 4, wherein the scanning system is configured to provide the first oscillating magnetic field perpendicular to the second oscillating magnetic field.
8. An inspection tool according to clause 4, wherein the scanning system is configured to operate the first oscillating magnetic field at a different frequency than the second oscillating magnetic field.
9. An inspection tool according to clause 4, wherein the scanning system is configured to operate the first oscillating magnetic field and the second oscillating magnetic field such that the first and second oscillating magnetic field are phase-locked.
10. An inspection tool according to clause 1, further comprising a detector system to detect back-scattered or secondary charged particles from the sample.
11. An inspection tool according to clause 10, wherein the detector system comprises an imaging system to image the back-scattered or secondary charged particles from the sample directly on a detector.
12. An inspection tool according to clause 10, wherein the detector system comprises a microwave cavity configured to provide an oscillating magnetic field similar to the first oscillating magnetic field to periodically deflect the charged particles from the sample to form an image on a detector.
13. An inspection tool according to clause 12, wherein the detector system comprises a lens system to focus the back-scattered or secondary charged particles from the sample before or after being deflected by the microwave cavity.
14. An inspection tool according to clause 10, wherein the detector system is configured to deflect the back-scattered or secondary charged particles from the sample in a deflection pattern similar to the scanning pattern to form an image on a detector.
15. An inspection tool according to clause 14, wherein the detector system and the scanning system are configured such that the deflection pattern of the detector system and the scanning pattern are phase-locked.
16. An inspection tool according to clause 14, wherein the detector system and the scanning system are configured such that the deflection pattern of the detector system and the scanning pattern have a phase difference of 90 degrees.
17. An inspection tool according to clause 1, further comprising an objective lens arranged between the scanning system and the sample holder, wherein the scanning system includes a counteracting microwave cavity configured to deflect the charged particle beam from the microwave cavity providing the first oscillating magnetic field towards an optical axis or origin of the objective lens.
18. An inspection tool according to clause 10, further comprising a beam separator to direct the charged particles from the sample towards the detector system.
19. An inspection tool according to clause 18, wherein the beam separator is a Wien filter.
20. An inspection tool according to clause 18, wherein the beam separator is arranged between the sample holder and the scanning system.
21. An inspection tool according to clause 18, wherein said microwave cavity is arranged between the sample holder and the beam separator.
22. An inspection tool according to clause 21, wherein another microwave cavity is arranged between the beam separator and the detector system to counteract the periodic deflection imposed on the back-scattered or secondary charged particles from the sample by the microwave cavity arranged between the sample holder and the beam separator.
23. An inspection tool according to clause 1, wherein the scanning system is configured to provide one or more oscillating magnetic fields that are higher-order harmonics of the first oscillating magnetic field to be combined with the first oscillating magnetic field to approximate a triangular-shaped oscillating magnetic field.
24. A method of scanning a sample in an inspection tool, the method comprising:
   a. generating a charged particle beam;
   b. passing the charged particle beam through a microwave cavity and towards a sample to scan the charged particle beam over an area of the sample in a scanning pattern
25. A method according to clause 24, wherein the charged particle beam is continuously scanned over an area of the sample in a scanning pattern.
26. A method according to clause 24, wherein the charged particle beam is an electron beam.
27. A method according to clause 24, wherein the scanning pattern is a 2D pattern.
28. A method according to clause 27, wherein the scanning pattern is a Lissajous pattern.
29. A method according to clause 24, further comprising the step of capturing back-scattered or secondary charged particles from the sample and imaging said charged particles on a detector.
30. A method according to clause 29, wherein a further microwave cavity is provided to deflect said back-scattered or secondary charged particles from the sample to form an image on the detector in accordance with a deflection pattern.
31. A method according to clause 25, wherein the deflection pattern is similar to the scanning pattern.
32. A non-transitory computer readable medium storing a set of instructions that is executable by one or more processors of an inspection tool to cause the inspection tool to perform a method of inspecting a sample, the method comprising:
   a. activating a charged particle source to generate a charged particle beam;
   b. operating a microwave cavity to scan the charged particle beam passing through the microwave cavity and towards a sample over an area of the sample in a scanning pattern.
33. A non-transitory computer readable medium according to clause 32, wherein the scanning pattern is a 2D pattern.
34. A non-transitory computer readable medium according to clause 33, wherein the scanning pattern is a Lissajous pattern.
35. A non-transitory computer readable medium according to clause 32, wherein the set of instructions that is executable by one or more processors of an inspection tool cause the inspection tool to further perform deflecting back-scattered or secondary charged particles from the sample to form an image on the detector in accordance with a deflection pattern.
36. A non-transitory computer readable medium according to clause 35, wherein the deflection pattern is similar to the scanning pattern.
37. An inspection tool comprising:
   - a charged particle source to generate charged particles;
   - a first microwave deflection cavity to direct charged particles from the charge particle source towards a sample,
   wherein the first microwave deflection cavity is configured to scan the sample at a scan rate in excess of 1 GHz.
38. An inspection tool according to clause 37, wherein the charged particle source is an electron source.
39. An inspection tool according to clause 37, further comprising a second microwave deflection cavity to direct secondary charged particles generated in response to the charged particles directed at the sample impacting the sample towards a detector.
40. An inspection tool according to clause 37, wherein the first and second microwave deflection cavity are configured to be operated in sync.
41. A method of scanning a sample in an inspection tool, the method comprising:
   a. generating charged particles via a charged particle source; and
   b. passing the charged particles through a first microwave deflection cavity and towards a sample to enable the sample to be scanned at a scan rate in excess of 1 GHz.
42. A method according to clause 41, wherein the charged particle source is an electron source.
43. A method according to clause 41, further comprising in response to the charged particles directed at the sample impacting the sample and causing secondary charged particles to be generated, passing the secondary charged particles through a second microwave deflection cavity that is synchronized with the first microwave deflection cavity to cause the secondary charged particles to be deflected towards a detector.
44. A method according to clause 41, further comprising scanning the sample in a Lissajous pattern at a scan rate in excess of 1 GHz.
45. A method according to clauses 44, wherein the Lissajous pattern is imaged directly on the detector.
46. A method according to clause 43, wherein the first and second microwave deflection cavity are synchronized with a non-zero phase difference.
47. A non-transitory computer readable medium storing a set of instructions that is executable by one or more processors of an inspection tool to cause the inspection tool to perform a method of inspecting a sample , the method comprising:
   a. activating a charged particle source to generate charged particles;
   b. operating a first microwave deflection cavity to scan a sample with the charged particles passing the first microwave deflection cavity and towards the sample at a scan rate in excess of 1 GHz.
48. A non-transitory computer readable medium according to clause 47, wherein the set of instructions that is executable by one or more processors of an inspection tool cause the inspection tool to further perform operating a second microwave deflection cavity in sync with the first microwave deflection cavity to cause secondary charged particles generated in response to charged particles being directed at the sample and impacting the sample to be deflected towards a detector.
49. A non-transitory computer readable medium according to clause 47, wherein operating the first microwave deflection cavity causes the sample to be scanned in a Lissajous pattern at a scan rate in excess of 1 GHz.

It will be appreciated that the embodiments of the present disclosure are not limited to the exact construction that has been described above and illustrated in the accompanying drawings, and that various modifications and changes may be made without departing from the scope thereof. The present disclosure has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. An inspection tool including:
- a charged particle source to provide a charged particle beam;
- a sample holder to hold a sample; and
- a scanning system configured to scan the charged particle beam over an area of the sample in a scanning pattern,
wherein the scanning system comprises a microwave cavity to provide a first oscillating magnetic field to periodically deflect the charged particle beam in order to scan the charged particle beam over the area of the sample.

2. An inspection tool according to claim 1, wherein the charged particle beam is an electron beam.

3. An inspection tool according to claim 1, wherein the scanning system is configured to continuously scan the charged particle beam over the area of the sample.

4. An inspection tool according to claim 1, wherein the scanning system is configured to provide a second oscillating magnetic field different from the first oscillating magnetic field to periodically deflect the charged particle beam in order to scan the charged particle beam over the area of the sample.

5. An inspection tool according to claim 4, wherein said microwave cavity configured to provide the first oscillating magnetic field is also configured to provide the second oscillating field.

6. An inspection tool according to claim 4, wherein the microwave cavity is a first microwave cavity, and wherein the scanning system comprises a second microwave cavity configured to provide the second oscillating magnetic field.

7. An inspection tool according to claim 4, wherein the scanning system is configured to provide the first oscillating magnetic field perpendicular to the second oscillating magnetic field.

8. An inspection tool according to claim 4, wherein the scanning system is configured to operate the first oscillating magnetic field at a different frequency than the second oscillating magnetic field.

9. An inspection tool according to claim 4, wherein the scanning system is configured to operate the first oscillating magnetic field and the second oscillating magnetic field such that the first and second oscillating magnetic field are phase-locked.

10. An inspection tool according to claim 1, further comprising a detector system to detect back-scattered or secondary charged particles from the sample.

11. An inspection tool according to claim 10, wherein the detector system comprises an imaging system to image the back-scattered or secondary charged particles from the sample directly on a detector.

12. An inspection tool according to claim 10, wherein the detector system comprises a microwave cavity configured to provide an oscillating magnetic field similar to the first oscillating magnetic field to periodically deflect the charged particles from the sample to form an image on a detector.

13. An inspection tool according to claim 12, wherein the detector system comprises a lens system to focus the back-scattered or secondary charged particles from the sample before or after being deflected by the microwave cavity.

14. An inspection tool according to claim 10, wherein the detector system is configured to deflect the back-scattered or secondary charged particles from the sample in a deflection pattern similar to the scanning pattern to form an image on a detector.

15. A method of scanning a sample in an inspection tool, the method comprising:
a. generating a charged particle beam;
b. passing the charged particle beam through a microwave cavity and towards a sample to scan the charged particle beam over an area of the sample in a scanning pattern
